(19) Europäisches Patentamt
European Patent Office
Office européen des brevets

(11) Veröffentlichungsnummer : **0 089 507**
**B1**

(12) # EUROPÄISCHE PATENTSCHRIFT

(45) Veröffentlichungstag der Patentschrift : **15.04.87**

(51) Int. Cl.[4] : **G 03 F 7/08**

(21) Anmeldenummer : **83101810.6**

(22) Anmeldetag : **24.02.83**

(54) **Lichtempfindliches Gemisch auf Basis von Diazoniumsalz-Polykondensationsprodukten und daraus hergestelltes lichtempfindliches Aufzeichnungsmaterial.**

(30) Priorität : **18.03.82 US 359456**

(43) Veröffentlichungstag der Anmeldung : **28.09.83 Patentblatt 83/39**

(45) Bekanntmachung des Hinweises auf die Patenterteilung : **15.04.87 Patentblatt 87/16**

(84) Benannte Vertragsstaaten : **DE**

(56) Entgegenhaltungen :
**CHEMICAL ABSTRACTS, Band 80, Nr. 12, 25. März 1974, Seite 407, Nr. 65521s, Columbus, Ohio, USA**

(73) Patentinhaber : **AMERICAN HOECHST CORPORATION**
**Route 202-206 North**
**Somerville, N.J. 08876 (US)**

(72) Erfinder : **Bentley, Trisha**
**31 W. Brown Street**
**Somerville New Jersey 08876 (US)**
Erfinder : **Walls, John E.**
**46 Center Street**
**Annandale New Jersey 08801 (US)**
Erfinder : **Dhillon, Major S.**
**896 C Merritt Dr.**
**Hillsborough New Jersey 08876 (US)**

(74) Vertreter : **Euler, Kurt Emil, Dr.**
**KALLE Niederlassung der Hoechst AG Rheingausstrasse 190 Postfach 3540**
**D-6200 Wiesbaden 1 (DE)**

**EP 0 089 507 B1**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die vorliegende Erfindung betrifft lichtempfindliche Gemische auf Basis von Diazoniumsalz-Polykondensationsprodukten sowie daraus hergestellte vorsensibilisierte Aufzeichnungsmaterialien, z. B. Flachdruckplatten, die eine verbesserte Beständigkeit gegenüber Wärme und bzw. oder Feuchtigkeit besitzen.

Zu den genannten Diazoniumsalz-Polykondensationsprodukten gehören höhermolekulare Gemische, die z. B. durch Kondensation von bestimmten aromatischen Diazoniumsalzen mit aktiven Carbonylverbindungen wie Formaldehyd in einem sauren Kondensationsmedium erhalten werden und u. a. in den US-A 2 063 631 und 2 667 415 beschrieben sind.

In jüngerer Zeit wurden verbesserte Diazoniumverbindungen der oben erwähnten Art entwickelt, die eine höhere Lichtempfindlichkeit besitzen, besser auf den Trägermaterialien haften und weniger empfindlich gegenüber Feuchtigkeit sind. Dazu gehören Polykondensationsprodukte aus wiederkehrenden Einheiten $A-N_2X$ und B, die durch zweibindige, von einer kondensationsfähigen Carbonylverbindung abgeleitete Zwischenglieder verbunden sind, wobei die Einheiten $A-N_2X$ sich aus Verbindungen der allgemeinen Formel

$$(R^1-R^3-)_pR^2-N_2X$$

ableiten und wobei

X das Anion der Diazoniumverbindung,
p eine ganze Zahl von 1 bis 3,
$R^1$ einen carbocyclischen oder heterocyclischen aromatischen Rest mit mindestens einer kondensationsfähigen Position,
$R^2$ eine Arylengruppe der Benzol- oder Naphthalinreihe,
$R^3$ eine Einfachbindung oder eine der Gruppen :
$-(CH_2)_q-NR^4-$,
$-O-(CH_2)_r-NR^4-$,
$-S-(CH_2)_r-NR^4-$,
$-S-CH_2-CO-NR^4-$,
$-O-R^5-O-$,
$-O-$,
$-S-$ oder
$-CO-NR^4-$

bedeuten, worin

q eine Zahl von 0 bis 5,
r eine Zahl von 2 bis 5,
$R^4$ Wasserstoff, eine Alkylgruppe mit 1 bis 5 C-Atomen, eine Aralkylgruppe mit 7 bis 12 C-Atomen oder eine Arylgruppe mit 6 bis 12 C-Atomen, und
$R^5$ eine Arylengruppe mit 6 bis 12 C-Atomen ist, und
B den von Diazoniumgruppen freien Rest eines aromatischen Amins, Phenols, Thiophenols, Phenolethers, aromatischen Thioethers, aromatischen Kohlenwasserstoffs, einer aromatischen heterocyclischen Verbindung oder eines organischen Säureamids bedeutet,

wobei das Kondensationsprodukt im Mittel 0,01 bis 50 Einheiten B je Einheit $A-N_2X$ enthält.

Verbindungen dieses Typs sind in der US-A 3 867 147 beschrieben.

Eine weitere Gruppe hochlichtempfindlicher Diazoniumsalz-Kondensationsprodukte sind in der EP-A 61 150 beschrieben.

Diese Verbindungen sind Polykondensationsprodukte aus wiederkehrenden Einheiten der allgemeinen Typen

$$[A-N_2X] \text{ und } [Q],$$

in denen A der Rest einer Verbindung der allgemeinen Formel I

(Siehe Formel I Seite 3 f.)

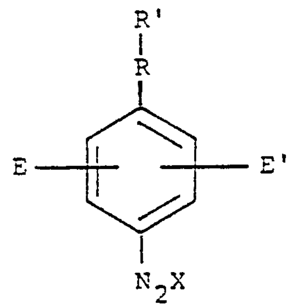

(I)

ist, worin

R′ eine gegebenenfalls substituierte Phenylgruppe darstellt,

R —NH—, —S—, —O—, $—CH_2—$ oder eine Einfachbindung ist,

E und E′ gleich oder verschieden sein können und Alkyl- oder Alkoxygruppen mit 1 bis 4 C-Atomen oder Wasserstoffatome sind und

X das Anion des Diazoniumsalzes ist,

Q der Rest einer Verbindung der allgemeinen Formel II

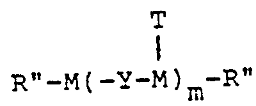

(II)

ist, worin

R″ $—CH_2OH$, $—C(OH)(CH_3)_2$, $—CH_2O(CH_2)_nCH_3$, $—CH_2OCOCH_3$, $—CH_2Cl$ oder $—CH_2Br$,

n 0 oder eine Zahl von 1 bis 3,

M der Rest eines aromatischen Kohlenwasserstoffs, Phenolethers, aromatischen Thioethers, aromatischen Amins, aromatischen Sulfons, aromatischen Ketons oder Diketons,

m eine Zahl von 0 bis 9,

Y $—CH_2—$ oder $—CH_2OCH_2—$ und

T ein Wasserstoffatom ist, wenn Y $—CH_2—O—CH_2—$ bedeutet, und ein Rest R″ ist, wenn Y $—CH_2—$ bedeutet.

Diese Kondensationsprodukte werden hergestellt, indem man

a) in einem stark sauren Medium eine Verbindung der Formel R″—M—R″ so lange und bei solcher Temperatur kondensiert, daß ein Kondensationsprodukt der Formel II gebildet wird, worin die Symbole die oben angegebene Bedeutung haben, und

b) das erhaltene Vorkondensationsprodukt in stark saurem Medium mit einer Verbindung der Formel I kondensiert, worin die Symbole ebenfalls die oben angegebene Bedeutung haben.

Zwar weisen die in jüngerer Zeit entwickelten hochlichtempfindlichen Diazoverbindungen hinsichtlich ihrer Qualität und Lichtempfindlichkeit eine Reihe von Vorteilen auf, was sie besonders geeignet erscheinen läßt für Anwendungsgebiete, in denen die Belichtung bei geringer Lichtenergie stattfindet, einschließlich Laserbelichtung, doch stellt ihre geringere Wärmebeständigkeit einen großen Nachteil dar. Während viele der weniger lichtempfindlichen niedermolekularen Diazoverbindungen unter üblichen Bedingungen eine Lagerfähigkeit von mehreren Wochen oder Monaten besitzen, beträgt die Lagerfähigkeit von sensibilisierten Druckplatten, die mit den erwähnten neuentwickelten Gemischen beschichtet wurden, nur wenige Stunden, insbesondere bei relativ hohen Lagertemperaturen bis 38 °C.

Bekannte Stabilisatoren für im Flachdruck verwendete Diazoniumverbindungen sind z. B. Aryl- und Halogenarylsulfonsäuren gemäß der US-A 2 649 373 ; Phosphor- und Sulfonsäuren gemäß US-A 3 679-419 ; Benzophenonverbindungen gemäß US-A 3 503 330 und Tetrafluoroborate gemäß US-A 3 933 499. In der US-A 4 172 729 wird eine vorsensibilisierte, eine Diazoverbindung enthaltende Flachdruckplatte mit verbesserter Lagerfähigkeit und Druckleistung beschrieben, die als Stabilisator bis zu 5 % Oxalsäure oder eines ihrer Salze enthält. Zum Vergleich wird in dieser Patentschrift auch die Verwendung anderer Zusätze, wie Citronen-, Phosphor-, Sulfon-, Bor-, Schwefel-, Polyphosphor-, Adipin-, Sulfamin- und Weinsäure, sowie von Glycin und bestimmten Salzen beschrieben.

Es ist Aufgabe der vorliegenden Erfindung, hochlichtempfindliche Gemische auf Basis von Diazoniumsalz-Polykondensationsprodukten vorzuschlagen, die eine erhöhte Beständigkeit gegen Wärme und/oder Feuchtigkeit bzw. eine verbesserte Lagerfähigkeit aufweisen.

Gegenstand der Erfindung ist ein lichtempfindliches Gemisch, das ein Diazoniumsalz-Polykondensationsprodukt und eine Aminosäure enthält. Das erfindungsgemäße Gemisch ist dadurch gekennzeichnet, daß die Aminosäure Asparagin, Alanin, Arginin, Asparaginsäure, Citrullin, Dihydroxyphenylalanin, Glutaminsäure, Isoleucin, Methionin oder Threonin ist.

Zu den Diazoniumsalz-Polykondensationsprodukten, die erfindungsgemäß stabilisiert werden, gehören diejenigen der vorstehend genannten allgemeinen Formeln. Dabei handelt es sich z. B. um Kondensationsprodukte von Diphenylamin-4-diazoniumsulfat und Paraformaldehyd in Schwefelsäure, die als Tetrachlorozinkate isoliert werden, die Kondensationsprodukte aus 3-Methoxy-diphenylamin-4-diazoniumsulfat und 4,4'-Bis-methoxymethyldiphenylether in Phosphorsäure, die als Naphthalin-2-sulfonat isoliert werden. Kondensationsprodukte aus Diphenylamin-4-diazoniumsulfat und Paraformaldehyd in Phosphorsäure, die als Hexafluorophosphate isoliert werden ; und die Produkte der Kondensation eines oligomeren Homokondensats, das z. B. aus 4,4'-Bis-methoxymethyl-diphenylether hergestellt worden ist, mit 3-Alkoxy-4-diazo-diphenylaminsulfat in Phosphorsäure, die als Mesitylensulfonat isoliert werden. Es handelt sich hier um die oben bezeichneten Kondensationsprodukte aus Verbindungen der Formel I und II.

Diazoniumverbindungen, denen die erfindungsgemäßen Stabilisatoren mit dem größten Erfolg zugesetzt werden können, sind jene hochlichtempfindlichen Verbindungen, die im Bereich von 350 bis 390 nm ein Absorptionsvermögen von nicht mehr als 45 % besitzen, gemessen mit einem Perkin-Elmer Spektrometer, Modell 559, unter Standardprüfbedingungen.

Durch die erfindungsgemäßen Stabilisatoren wird nicht nur eine Stabilisierung solcher hochlichtempfindlicher Diazoniumverbindungen erreicht, die Stabilisierung erfolgt überdies ohne nennenswerte Beeinträchtigung der Lichtempfindlichkeit oder der Bildqualität.

Die im Rahmen der vorliegenden Erfindung als Stabilisatoren verwendeten ausgewählten Aminosäuren sind Asparagin, Alanin, Arginin, Asparaginsäure, Citrullin, Dihydroxyphenylalanin, Glutaminsäure, Isoleucin, Methionin, Threonin und deren Gemische. Bevorzugt werden Citrullin, Asparagin, Dihydroxyphenylalanin und Glutaminsäure.

Allgemein sind diejenigen Aminosäuren geeignet, mit deren Hilfe die Zeit bis zur Zersetzung einer Diazoniumverbindung bei 100 °C unter den nachstehend beschriebenen Prüfungsbedingungen um mindestens das 2,5-fache verlängert wird.

Das Verhältnis von Diazoniumverbindung zu als Stabilisator verwendeter Säure, das zur Gewährleistung einer wirkungsvollen Stabilisierung gewählt werden muß, hängt sowohl von der Art der Diazoniumverbindung als auch von der gewählten Aminosäure ab. Im allgemeinen werden mit 0,1 bis 2 Gewichtsteilen Stabilisator je Gewichtsteil Diazoniumverbindung gute Ergebnisse erzielt. Meistens genügen 0,25 bis 1 Gewichtsteile Aminosäure auf 1 Gewichtsteil Diazoniumverbindung.

Die erfindungsgemäßen stabilisierten lichtempfindlichen Gemische können in gewohnter Weise zu Reproduktionsschichten verarbeitet werden. Sie werden in einem geeigneten Lösemittel, z. B. in Wasser oder einem organischen Lösemittel, gelöst, auf Träger aufgebracht und getrocknet, so daß Druckplatten, Farbprüffolien, Resists für gedruckte Schaltungen usw. erhalten werden. Geeignete Trägermaterialien sind u. a. aufgerauhtes oder anodisiertes Aluminium, transparente Kunststoffolien, Papier oder Kupfer.

Die Beschichtungsgemische können natürlich noch weitere bekannte Zusätze enthalten, wie Pigmente, Farbstoffe, polymere Bindemittel, Weichmacher, Sensibilisatoren, Netzmittel, Indikatoren usw. Geeignete Zusätze und polymere Bindemittel sind in der US-A 3 867 147 beschrieben.

Alle Zusätze sollten so ausgewählt werden, daß sie sowohl mit der Diazoniumverbindung, dem Stabilisator und dem gegebenenfalls verwendeten polymeren Bindemittel als auch mit dem eingesetzten Lösemittel gut verträglich sind. Geeignete Lösemittel sind z. B. Wasser, niedere aliphatische Alkohole und Ether sowie aromatische und aliphatische Kohlenwasserstoffe. Geeignete polymere Bindemittel umfassen in Wasser oder wäßrig-alkalischen Lösungen lösliche Substanzen, wie Polyvinylalkohol, Polyacrylamide, Copolymere aus vinylaromatischen Verbindungen und sauren Comonomeren wie Maleinsäureanhydrid. Es können aber auch wasserunlösliche Bindemittel wie Phenol- und Alkydharze und Acrylpolymere verwendet werden. Polymere Bindemittel werden gegebenenfalls in Mengen zwischen 1 und 50 Gewichtsteilen je Gewichtsteil Diazoniumverbindung zugesetzt.

Die erfindungsgemäßen stabilisierten lichtempfindlichen Gemische werden am vorteilhaftesten hergestellt, indem man die Diazoniumverbindung und die Aminosäure in einem Lösemittel löst, in dem beide Stoffe löslich sind. Diese Lösung kann noch weitere gelöste oder dispergierte Zusätze enthalten. Das Auftragen der Lösung auf einen geeigneten Träger erfolgt in bekannter Weise, z. B. durch Tamponieren, Schleudern oder einfaches Überwischen ; anschließend wird das Lösemittel durch Trocknen der Beschichtung entfernt.

Anhand der folgenden Beispiele wird die Erfindung erläutert :

## Vergleichsbeispiel A

Eine sensibilisierte Druckplatte wurde folgendermaßen hergestellt : Eine Aluminiumplatte wurde mechanisch aufgerauht. Die aufgerauhte Platte wurde gut abgespült und anschließend durch Behandlung mit Polyvinylphosphonsäure hydrophiliert. Die so behandelte Platte wurde wieder gut abgespült und getrocknet.

Ein Stück dieser Platte (50 × 50 cm) wurde mit einer 0,2 %igen Lösung in 2-Methoxyethanol des Produktes, das durch Kondensation von Diphenylamin-4-diazoniumsulfat und Paraformaldehyd in Schwefelsäure erhalten und als Hexafluorophosphat isoliert wurde (Diazo A), durch Schleudern beschichtet. Anschließend wurde die Druckplatte getrocknet.

## Vergleichsbeispiel B

Vergleichsbeispiel A wurde wiederholt mit der Ausnahme, daß die verwendete Diazoniumverbindung aus dem Homokondensationsprodukt aus 4,4'-Bis-methoxymethyl-diphenylether, das mit 3-Methoxy-4-diazo-diphenylaminsulfat weiterkondensiert und anschließend als Mesitylensulfonat isoliert wurde, bestand. Die erhaltene Diazoniumverbindung wurde als Diazo B bezeichnet. Diese Diazoniumverbindung und weitere analoge Diazoniumverbindungen werden in der EP-A 61 150 beschrieben.

Die Lichtempfindlichkeit und Beständigkeit der Vergleichsplatten wurde folgendermaßen gemessen : Die Platten wurden in mehrere 12,5 × 12,5 cm große Stücke geschnitten, und eines der Stücke wurde mittels einer Quecksilberdampflampe durch eine Testvorlage mit einem 21-Stufen-Stauffer-Keil belichtet, wobei sich die Dichte zwischen benachbarten Stufen um den Faktor $\sqrt{2}$ unterschied. Der Vakuumrahmen war mit einer Lichtquelle ausgestattet, die eine genaue automatische Blendeneinstellung ermöglichte. Die Belichtung erfolgte in Einheiten (1 Einheit = 12 $mJ/cm^2$) ; dabei wurde jedes Plattenmuster mit 2 Einheiten belichtet. Anschließend erfolgte die Entwicklung mit Western Jet Black Lacquer Entwickler (Hersteller Western Litho). Nach dem Entwickeln wiesen die Vergleichsplatten klare, hydrophile Bildhintergrundstellen auf. Der Stufenkeil der Vergleichsplatte A hatte zwei gedeckte und drei teilweise gedeckte Stufen, daher die Bezeichnung 2/3. Die Vergleichsplatte B hatte vier gedeckte und zwei teilweise gedeckte Stufen, wurde also mit 4/2 bezeichnet.

Die Wärmebeständigkeit der Platten wurde folgendermaßen bestimmt :

Die unbelichteten Vergleichsplatten wurden zur Durchführung eines Alterungstests in einen auf 100 °C geheizten Trockenschrank gelegt. Alle fünf Minuten wurde eines der Plattenstücke aus dem Trockenschrank genommen, durch den Stufenkeil hindurch belichtet und gemäß der obigen Beschreibung ausgewertet. Insgesamt dauerte dieser Versuch eine Stunde.

Die Veränderung der Keilstufen im Laufe der beschleunigten Alterung ist ein Maßstab für die Lagerfähigkeit. Eine Zunahme der gedeckten und/oder der Zwischenstufen läßt auf eine unerwünschte Zersetzung der Beschichtung schließen. Eine Druckplatte gilt als für Druckzwecke ungeeignet, wenn die Hydrophilie soweit abnimmt, daß die Platte nach dem Entwickeln auf ihrer gesamten Oberfläche oder zumindest auf dem überwiegenden Teil ihrer Oberfläche Tonerscheinungen aufweist, so daß keine Keilstufen mehr erkennbar sind.

Mit dem beschriebenen Prüfverfahren wurde festgestellt, daß die Vergleichsplatte A nach 15 Minuten Verweildauer bei 100 °C vollständige Zersetzungserscheinungen zeigte ; nach 10 Minuten hatte sich die Zahl von gedeckten und teilweise gedeckten Keilstufen auf 5/4 erhöht. Bei Vergleichsplatte B war nach 10 Minuten vollständige Zersetzung zu verzeichnen, die Zahl der Stufen hatte sich nach 5 Minuten auf 7/5 erhöht. Keine dieser ohne einen Stabilisator hergestellten Vergleichsplatten wäre für Druckzwecke geeignet gewesen.

## Beispiele 1 bis 10

Auf die in den Vergleichsbeispielen A und B beschriebene Weise wurden fünf verschiedene Gemische in Form von 0,2 gew.-%igen Lösungen der jeweiligen Diazoniumverbindung A oder B in 2-Methoxyethanol unter Beimischung von 0,2 Gew.-% je einer der unten angegebenen Aminosäuren hergestellt. Mit diesen Lösungen wurden Aluminiumplatten beschichtet, getrocknet und den bereits beschriebenen Prüfungen unterzogen. Die Prüfungsergebnisse für die einzelnen Aminosäuren sind in Tabelle 1 festgehalten.

Die Zahlen in der Zeitspalte von Tabelle 1 geben die Verweildauer im Trockenschrank an, nach der das betreffende Gemisch bis zu dem Punkt abgebaut war, ab dem keine Differenzierung der einzelnen Stufen mehr möglich war. Die Keilstufenangaben gelten für das Plattenstück, das jeweils 5 Minuten vor der unbrauchbaren Probe aus dem Wärmeschrank genommen wurde.

## Beispiele 11 bis 25

Wie in den Beispielen 1 bis 10 wurden aus den dort verwendeten Kondensationsprodukten, jedoch in Verbindung mit anderen Aminosäuren, weitere Gemische hergestellt. Aus den nachstehend dargelegten Gründen waren die hier eingesetzten Aminosäuren jedoch nicht in der Lage, die Wärmebeständigkeit sicherzustellen. Die Ergebnisse für diese Aminosäuren sind ebenfalls in Tabelle 1 enthalten.

Wie Tabelle 1 zeigt, wird die Wärmebeständigkeit der untersuchten Diazoniumverbindungen durch die Zugabe der in den Beispielen 1 bis 10 angegebenen ausgewählten Aminosäuren gegenüber den Vergleichsproben gesteigert. Sämtliche in den Beispielen 11 bis 25 untersuchten Stoffe führten zu keiner Verbesserung der Hitzebeständigkeit und erwiesen sich sogar im Vergleich mit den Vergleichsproben als völlig inakzeptabel. Alle letztgenannten Platten tonten bereits nach 5 Minuten Verweildauer bei 100 °C.

(Siehe Tabelle 1 Seite 6 ff.)

Tabelle 1

| Beispiel | Aminosäure | DIAZO A | | | DIAZO B | | |
|---|---|---|---|---|---|---|---|
| | | Zeit bei 100°C Minuten | Keilstufen Anfang | Keilstufen Ende | Zeit bei 100°C Minuten | Keilstufen Anfang | Keilstufen Ende |
| 1 | Asparagin | 50 | 3/4 | 5/4 | 45 | 5/3 | 6/6 |
| 2 | Alanin | 35 | 2/3 | 4/5 | 30 | 4/2 | 5/5 |
| 3 | Arginin x HCl | 45 | 1/3 | 3/3 | 40 | 3/2 | 4/4 |
| 4 | Asparaginsäure | 45 | 3/4 | 4/4 | 35 | 5/3 | 6/4 |
| 5 | Citrullin | 60 | 3/3 | 3/3 | 60 | 5/5 | 5/4 |
| 6 | Dihydroxyphenylalanin | 55 | 3/3 | 4/3 | 45 | 5/2 | 6/2 |
| 7 | Glutaminsäure | 55 | 2/4 | 4/2 | 40 | 4/3 | 5/3 |
| 8 | Isoleucin | 40 | 3/4 | 3/4 | 30 | 5/3 | 5/4 |
| 9 | Methionin | 45 | 3/3 | 3/5 | 40 | 5/3 | 5/5 |
| 10 | Threonin | 40 | 3/3 | 4/6 | 25 | 5/2 | 5/7 |
| — | Vergleich | 15 | 2/2 | 5/4 | 10 | 4/2 | 7/5 |
| 11 | Cystin | 5 | Ton nach 5 Minuten | | 5 | Ton nach 5 Minuten | |
| 12 | Ethionin | 5 | " " " " | | 5 | " " " " | |
| 13 | Histidin x HCl | 5 | " " " " | | 5 | " " " " | |
| 14 | Leucin | 5 | " " " " | | 5 | " " " " | |
| 15 | Lysin-Dihydrochlorid | 5 | " " " " | | 5 | " " " " | |

Tabelle 1 (Fortsetzung)

| Beispiel | Aminosäure | DIAZO A: Zeit bei 100°C Minuten | DIAZO A: Keilstufen Anfang | DIAZO A: Keilstufen Ende | DIAZO B: Zeit bei 100°C Minuten | DIAZO B: Keilstufen Anfang | DIAZO B: Keilstufen Ende |
|---|---|---|---|---|---|---|---|
| 16 | Norleucin | 5 | " " | " " | 5 | " " | " " |
| 17 | Norvalin | 5 | " " | " " | 5 | " " | " " |
| 18 | Ornithin | 5 | " " | " " | 5 | " " | " " |
| 19 | Ornithin x HCl | 5 | " " | " " | 5 | " " | " " |
| 20 | Phenylalanin | 5 | " " | " " | 5 | " " | " " |
| 21 | Prolin | 5 | " " | " " | 5 | " " | " " |
| 22 | Tryptophan | 5 | " " | " " | 5 | " " | " " |
| 23 | Tyrosin | 5 | " " | " " | 5 | " " | " " |
| 24 | Valin | 5 | " " | " " | 5 | " " | " " |
| 25 | α-Aminobuttersäure | 5 | " " | " " | 5 | " " | " " |

**Patentansprüche**

1. Lichtempfindliches Gemisch, das ein Diazoniumsalz-Polykondensationsprodukt und eine Aminosäure enthält, dadurch gekennzeichnet, daß die Aminosäure Asparagin, Alanin, Arginin, Asparaginsäure, Citrullin, Dihydroxyphenylalanin, Glutaminsäure, Isoleucin, Methionin oder Threonin ist.

2. Lichtempfindliches Gemisch nach Anspruch 1, dadurch gekennzeichnet, daß das Diazoniumsalz-Polykondensationsprodukt ein Kondensationsprodukt aus wiederkehrenden Einheiten $A—N_2X$ und B ist, die durch zweibindige, von einer kondensationsfähigen Carbonylverbindung abgeleitete Zwischenglieder verbunden sind, wobei die Einheiten $A—N_2X$ sich aus Verbindungen der allgemeinen Formel

$$(R^1—R^3—)_pR^2—N_2X$$

ableiten und wobei

X das Anion der Diazoniumverbindung,
p eine ganze Zahl von 1 bis 3,
$R^1$ einen carbocyclischen oder heterocyclischen aromatischen Rest mit mindestens einer kondensationsfähigen Position,
$R^2$ eine Arylengruppe der Benzol- oder Naphthalinreihe,
$R^3$ eine Einfachbindung oder eine der Gruppen:
$—(CH_2)_q—NR^4—$,
$—O—(CH_2)_r—NR^4—$,
$—S—(CH_2)_r—NR^4—$,
$—S—CH_2—CO—NR^4—$,
$—O—R^5—O—$,
$—O—$,
$—S—$ oder
$—CO—NR^4—$

bedeuten, worin

q eine Zahl von 0 bis 5,
r eine Zahl von 2 bis 5,
$R^4$ Wasserstoff, eine Alkylgruppe mit 1 bis 5 C-Atomen, eine Aralkylgruppe mit 7 bis 12 C-Atomen oder eine Arylgruppe mit 6 bis 12 C-Atomen, und
$R^5$ eine Arylengruppe mit 6 bis 12 C-Atomen ist, und
B den von Diazoniumgruppen freien Rest eines aromatischen Amins, Phenols, Thiophenols, Phenolethers, aromatischen Thioethers, aromatischen Kohlenwasserstoffs, einer aromatischen heterocyclischen Verbindung oder eines organischen Säureamids bedeutet,

wobei das Kondensationsprodukt im Mittel 0,01 bis 50 Einheiten B je Einheit $A—N_2X$ enthält.

3. Lichtempfindliches Gemisch nach Anspruch 1, dadurch gekennzeichnet, daß es die Aminosäure in einer Menge von 0,1 bis 2 Gewichtsteilen je Gewichtsteil des Diazoniumsalz-Polykondensationsprodukts enthält.

4. Lichtempfindliches Aufzeichnungsmaterial aus einem Schichtträger und einer lichtempfindlichen Schicht, die aus einem lichtempfindlichen Gemisch gemäß Anspruch 1 besteht.

**Claims**

1. A light-sensitive mixture comprising a diazonium salt polycondensation product and an amino acid, characterized in that the amino acid is asparagine, alanine, arginine, aspartic acid, citrulline, dihydroxy phenylalanine, glutamic acid, isoleucine, methionine or threonine.

2. A light-sensitive mixture as claimed in claim 1, characterized in that the diazonium salt polycondensation product is a condensation product having repeating units $A—N_2X$ and B, which are connected by bivalent intermediate members derived from a carbonyl compound capable of condensation, the units $A—N_2X$ being derived from compounds of the general formula

$$(R^1—R^3—)_pR^2—N_2X$$

wherein

X is the anion of the diazonium compound,
p is an integer from 1 to 3,
$R^1$ is a carbocyclic or heterocyclic aromatic radical having at least one position capable of condensation,

$R^2$ is an arylene group of the benzene or naphthalene series,
$R^3$ is a single bond or one of the groups
$-(CH_2)_q-NR^4-$,
$-O-(CH_2)_r-NR^4-$,
$-S-(CH_2)_r-NR^4-$,
$-S-CH_2-CO-NR^4-$,
$-O-R^5-O-$,
$-O-$,
$-S-$ oder
. $-CO-NR^4-$

wherein

q is a number from 0 to 5,
r is a number from 2 to 5,
$R^4$ is hydrogen, an alkyl group having from 1 to 5 carbon atoms, an aralkyl group having from 7 to 12 carbon atoms or an aryl group having from 6 to 12 carbon atoms,
$R^5$ is an arylene group having from 6 to 12 carbon atoms, and
B stands for the radical, free from diazonium groups, of an aromatic amine, a phenol, a thiophenol, a phenol ether, an aromatic thioether, an aromatic hydrocarbon, an aromatic heterocyclic compound or an organic acid amide,

wherein the condensation product contains, on the average, from 0.01 to 50 units B per unit $A-N_2X$.

3. A light-sensitive mixture as claimed in claim 1, characterized in that it comprises the amino acid in an amount of from 0.1 to 2 parts by weight per part by weight of the diazonium salt polycondensation product.

4. A light-sensitive recording material having a layer support and a light-sensitive layer, wherein the layer consists of a light-sensitive mixture as claimed in claim 1.

**Revendications**

1. Mélange photosensible contenant un produit de polycondensation de sel de diazonium et un acide aminé, caractérisé en ce que l'acide aminé est l'asparagine, l'alanine, l'arginine, l'acide aspartique, la citrulline, la dihydroxyphénylalanine, l'acide glutamique, l'isoleucine, la méthionine ou la thréonine.

2. Mélange photosensible selon la revendication 1, caractérisé en ce que le produit de polycondensation de sel de diazonium est un produit de condensation constitué de motifs répétés $A-N_2X$ et B, qui sont reliés par des chaînons intermédiaires à deux liaisons, dérivés d'un composé carbonyle susceptible de condensation, les motifs $A-N_2X$ dérivant de composés de formule générale

$$(R^1-R^3-)_pR^2-N_2X$$

X représentant l'anion du composé diazonium,
p étant un nombre entier allant de 1 à 3,
$R^1$ représentant un reste aromatique carbocyclique ou hétérocyclique comportant au moins une position susceptible de condensation,
$R^2$ représentant un groupe arylène de la série du benzène ou de celle du naphtalène,
$R^3$ représentant une liaison simple ou l'un des groupes :
$-(CH_2)_q-NR^4-$,
$-O-(CH_2)_r-NR^4-$,
$-S-(CH_2)_r-NR^4-$,
$-S-CH_2-CO-NR^4-$,
$-O-R^5-O-$,
$-O-$,
$-S-$ ou
$-CO-NR^4-$,

dans lesquels

q est un nombre entier allant de 0 à 5,
r est un nombre entier allant de 2 à 5,
$R^4$ est un atome d'hydrogène, un groupe alkyle ayant de 1 à 5 atomes de carbone, un groupe aralkyle ayant de 7 à 12 atomes de carbone, ou un groupe aryle ayant de 6 à 12 atomes de carbone, et
$R^5$ est un groupe arylène ayant de 6 à 12 atomes de carbone, et
B représente le reste, exempt de groupes diazonium, d'une amine aromatique, d'un phénol, d'un

thiophénol, d'un éther phénolique, d'un thioéther aromatique, d'un hydrocarbure aromatique, d'un composé aromatique hétérocyclique ou d'un amide organique

le produit de condensation contenant en moyenne 0,01 à 50 motifs B par motif A—$N_2$X.

3. Mélange photosensible selon la revendication 1, caractérisé en ce que l'acide aminé est contenu en une quantité allant de 0,1 à 2 parties en poids par partie en poids du produit de polycondensation de sel de diazonium.

4. Matériau d'enregistrement photosensible consistant en un support de couche et une couche photosensible qui est constituée à partir d'un mélange photosensible selon la revendication 1.